# EUROPEAN PATENT APPLICATION

(11) **EP 2 439 846 A1**
(43) Date of publication of application: **11.04.2012**
(21) Application number: 10186725.7
(22) Date of filing: 06.10.2010
(51) Int. Cl.: H03K 3/011, H03K 3/0231, H03B 5/04, H03B 5/20

(54) **Temperature compensated RC oscillator**

(71) Applicant: NXP B.V., 5656 AG Eindhoven (NL)
(72) Inventor: Elend, Bernd, Redhill, Surrey RH1 1DL (GB)
(74) Representative: Williamson, Paul Lewis

(57) **Abstract**

An on-chip RC oscillator comprises a resistor arrangement and a capacitor arrangement at least one of which is tuneable. Trimming settings for the resistor arrangement and/or the capacitor arrangement are stored, and a trimming setting is applied to the resistor arrangement and/or the capacitor arrangement in dependence on a sensed temperature.

## Description

The present invention relates generally to clock circuits and, specifically, to an on-chip RC oscillator that is designed to compensate for temperature variation of the oscillation.

Microcontrollers are found in wide variety of products, such as electronic consumer devices and household appliances. A microcontroller should be clocked by a stable and accurate oscillating signal.

One method of generating a stable and accurate clock signal is to use a phase-locked loop (PLL) that receives an accurate reference signal from an external crystal oscillator. Manufacturing costs can be reduced, however, by generating the clock signal using an internal, on-chip oscillator as opposed to a more expensive external crystal oscillator.

An internal precision oscillator in a microcontroller can be an RC oscillator. A capacitor of the RC circuit is charged and discharged after the voltage across the capacitor reaches a lower and upper trigger voltage, respectively. The rate at which the capacitor is charged and discharged depends on the RC time constant of the RC circuit. The output frequency can be tuned by controlling either the capacitance of the capacitor and/or the resistance of the resistor in the RC circuit.

One way to perform this tuning is by means of digital control. A number in a register determines a set of capacitors that are switched in parallel, or a resistor configuration that has resistors in series, individual ones of which can be selectively short circuited.

At the end of production of a device, the oscillator is trimmed close to its target frequency by writing an appropriate number into the register. However, even though the frequency of the oscillator might meet the required target frequency perfectly after programming the register, the frequency might change over temperature and leave the allowed tolerance range.

In many applications, a microcontroller experiences a wide variation in its operating temperature. Temperature variation can affect the frequency of the clock signal output by the RC oscillator, and that clock signal may become insufficiently stable and not sufficiently accurate for the particular application. For example, the RC oscillator resistor resistance may change with temperature, i.e., the resistor has a positive or negative temperature coefficient. A change in resistance may affect not only the RC time constant, but also the trigger voltages at which the capacitor is charged and discharged.

In one example, an on-chip oscillator is desired that is capable to clock a CAN (controller area network) controller block. Such CAN controllers require that the clock frequency does not deviate more than a fixed percentage from its nominal frequency. The deviation value depends on the details of the bittiming parameters, but in any case it is less than 2%, in some cases even less than 1%. Since no external clock reference is available, there is currently no design available that meets this requirement over an ambient temperature range from -40°C up to +125°C.

One method of compensating for resistance changes caused by temperature variation in RC oscillators relies on matching resistors with positive temperature coefficients to resistors having negative temperature coefficients. Transistors and resistors may also be matched in a similar way to provide insensitivity to temperature variations. It can be difficult, however, to manufacture an on-chip resistor/transistor whose temperature coefficient inversely matches that of its paired resistor/transistor over the entire operating temperature range.

US 7 176 765 discloses an implementation of temperature compensation by controlling a comparator bias current.

According to the invention, there is provided an on-chip RC oscillator comprising:
a resistor arrangement and a capacitor arrangement which together define an RC time constant which governs the oscillator frequency, wherein at least one of the resistor arrangement and capacitor arrangement is tuneable,
a memory for storing trimming settings for the resistor arrangement and/or the capacitor arrangement;
a temperature sensor; and
a controller,
wherein the controller is adapted to apply a trimming setting to the resistor arrangement and/or the capacitor arrangement in dependence on the sensed temperature.

The oscillator of the invention uses the digital trimming arrangement, which can be used in the initial calibration and setting of the device, to implement temperature compensation in use. In this way, little additional hardware is required to implement the invention.

The resistor arrangement can be fixed, and the capacitor arrangement is then tuneable.

The controller is preferably adapted to select a trimming setting which has a value which varies at predetermined temperature thresholds. This provides a set of discrete settings, which results in a simpler control method, and avoids the need for large amounts of data to be stored, or complex models to be used to derive the required settings. The resulting frequency is kept within margins by the predetermined temperature threshold values.

The trimming settings can have hysteresis such that there are upper thresholds at which the trimming setting changes in response to an increasing temperature, and lower thresholds at which the trimming setting changes in response to a decreasing temperature. In this way, the frequency is stable at the temperatures where the trimming settings change, and rapid toggling of the output frequency is avoided.

The invention also provides a method of controlling the output frequency of an on-chip RC oscillator, wherein the oscillator comprises a resistor arrangement and a capacitor arrangement which together define an RC time constant which governs the oscillator frequency, wherein at least one of the resistor arrangement and capacitor arrangement is tuneable, wherein the method comprises:
storing trimming settings for the resistor arrangement and/or the capacitor arrangement;
sensing the temperature; and
applying a trimming setting to the resistor arrangement and/or the capacitor arrangement in dependence on the sensed temperature.

The invention will now be described with reference to the accompanying drawings, in which:
Figure 1 shows a known RC oscillator;
Figure 2 shows an oscillator of the invention; and
Figure 3 is used to explain the control method of the invention.

The invention provides an on-chip RC oscillator in which one or both of a resistor arrangement and a capacitor arrangement of the RC circuit are tuneable. A trimming setting is applied during operation of the oscillator to the tuneable resistor arrangement and/or the capacitor arrangement in dependence on a sensed temperature.

There are various different types of RC oscillator to which the invention can be applied.

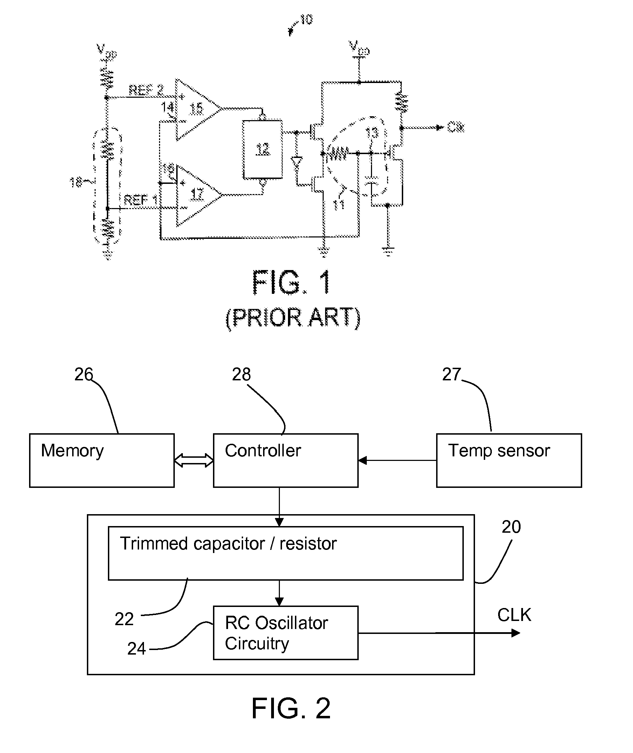

One example is shown in Figure 1, and is described in US 7 176 765.

The oscillator 10 has an RC circuit 11, and an RS latch 12 for switching between the output of two comparators 15, 17. An RC node 13 is coupled to a inverting input lead 14 of a discharge comparator 15 and to a non-inverting input lead 16 of a charge comparator 17.

Charge comparator 17 detects when the voltage on RC node 13 reaches a lower reference voltage, at which time RS latch 12 causes charge to accumulate on RC node 13. Discharge comparator 15 detects when the voltage on RC node 13 reaches a higher reference voltage, at which time RS latch 12 causes charge to discharge from RC node 13. The reference voltages are generated by a voltage divider 18 formed by a resistor string.

As the operating temperature of oscillator 10 changes, the resistance of the resistors in the resistor string change, thereby changing the reference voltages.

Other designs of RC oscillator do not use comparators in this way. For example, the resistor can be part of a current generator circuit, which determines the rate at which the capacitor is charged. When the capacitor is charged to a given voltage (sufficient to latch the output of a logic device), a shorting transistor is operated to discharge the capacitor. In this way, there is only one reference voltage level.

Other RC oscillator circuit will be known to those skilled in the art. The invention applies equally to all such designs, as long as the resistance and capacitance together govern the oscillator operating frequency.

Figure 2 shows the oscillator of the invention.

The RC oscillator 20 can be of any suitable known design, providing it has a digitally tuneable capacitor or resistor arrangement 22 as well as the other oscillator circuitry 24.

A tuneable resistor arrangement can comprise a string of resistors in series, with a respective shorting transistor in parallel with each resistor in the string (or only a sub-set of the resistors may need to be shortable). The gate voltages of the shorting transistors are controlled so that they function as binary switches.

A tuneable capacitor arrangement can comprise an array of capacitors in parallel, with a respective transistor in series with each capacitor in the array (or only a sub-set of the capacitors may need to be switchable into circuit). The gate voltages of the shorting transistors are controlled so that they again function as binary switches.

The trimmable capacitor or resistor arrangement is shown schematically as 22.

A memory 26 stores trimming settings for the resistor arrangement and/or the capacitor arrangement. The ambient temperature is measured by a temperature sensor 27. This is for measuring large scale temperature variations within the operating range of the oscillator. As such, it does not need to be highly sensitive or accurate, and temperature sensors suitable for this purpose are well known, and may be integrated on-chip.

A controller 28 applies a trimming setting to the resistor arrangement and/or the capacitor arrangement in dependence on the sensed temperature.

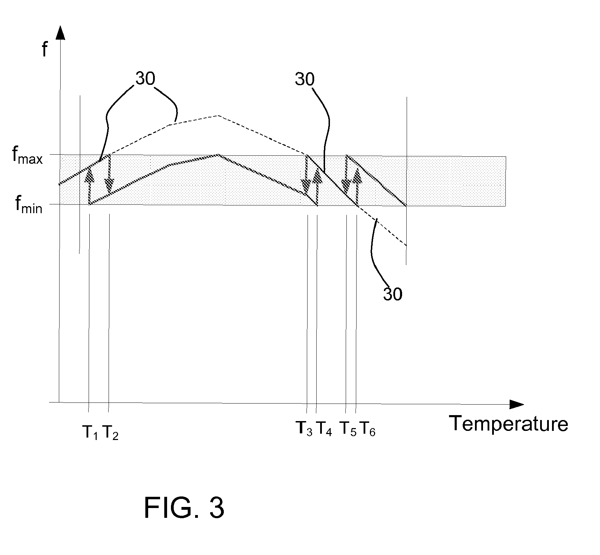

Figure 3 shows an example of the drift of an oscillator frequency over temperature.

Plot 30 is the temperature response with no temperature compensation. The average frequency is in the allowed frequency range between fₘᵢₙ and fₘₐₓ. However, at certain temperatures the frequency leaves the allowed range.

The invention makes use of the digitally trimming of the oscillator to provide temperature compensation.

Figure 3 gives one example of how the frequency can be adjusted in dependence of the temperature.

The controller 28 is adapted to select a trimming setting which has a value which varies at predetermined temperature thresholds T₁ to T₆.

The trimming settings have hysteresis such that there are upper temperature thresholds (T₂,T₄,T₆) at which the trimming setting changes in response to an increasing temperature, and lower thresholds (T₁,T₃,T₅) at which the trimming setting changes in response to a decreasing temperature.

In the example of Figure 3:
- If the temperate increases above T₂ the digital trim is changed to a fixed value X₂₃.
- If the temperate increases above T₄ the digital trim is changed to a fixed value X₄₅.
- If the temperate increases above T₆ the digital trim is changed to a fixed value X₆₇.
- If the temperate decreases below T₅ the digital trim is changed to a fixed value X₄₅.
- If the temperate decreases below T₃ the digital trim is changed to a fixed value X₂₃.
- If the temperate decreases below T₁ the digital trim is changed to a fixed value X₀₁.

The values for T₁/T₂, T₃/T₄ and T₅/T₆ represent temperature thresholds with hysteresis.

The temperature values, as well as the corresponding trimming setting (capacitance and/or resistance) are determined depending on the temperature dependence of the frequency. This example uses three pairs of temperature values, each pair giving a threshold region. The required number of thresholds (temperature pairs) can range from 1 to many more than 3.

The settings of the digital trim values X₀₁, X₂₃, X₄₅ and X₆₇ have to be determined during characterization of the device.

The fact that the frequency is digitally controlled allows an almost perfect compensation of the temperature drift.

This invention can be used for any oscillator. Of particular interest is oscillators that are used to clock the digital logic of a protocol controller. For example, one area of interest is in the field of "partial networking"; especially for "CAN" bus systems.

Partial networking function is for example of interest in the automotive industry.

Various modifications will be apparent to those skilled in the art.

## Claims

1. An on-chip RC oscillator comprising:
a resistor arrangement and a capacitor arrangement (22) which together define an RC time constant which governs the oscillator frequency, wherein at least one of the resistor arrangement and capacitor arrangement is tuneable,
a memory (26) for storing trimming settings for the resistor arrangement and/or the capacitor arrangement;
a temperature sensor (27); and
a controller (28),
wherein the controller is adapted to apply a trimming setting to the resistor arrangement and/or the capacitor arrangement in dependence on the sensed temperature.

2. An oscillator as claimed in claim 1, wherein the resistor arrangement is fixed and the capacitor arrangement is tuneable.

3. An oscillator as claimed in claim 1, wherein the resistor arrangement is tuneable and the capacitor arrangement is fixed.

4. An oscillator as claimed in any preceding claim, wherein the controller (28) is adapted to select a trimming setting which has a value which varies at predetermined temperature thresholds (T₁ - T₆).

5. An oscillator as claimed in claim 4, wherein the trimming settings have hysteresis such that there are upper thresholds (T₂,T₄,T₆) at which the trimming setting changes in response to an increasing temperature, and lower thresholds (T₁,T₃,T₅) at which the trimming setting changes in response to a decreasing temperature.

6. A method of controlling the output frequency of an on-chip RC oscillator, wherein the oscillator comprises a resistor arrangement and a capacitor arrangement (22) which together define an RC time constant which governs the oscillator frequency, wherein at least one of the resistor arrangement and capacitor arrangement is tuneable, wherein the method comprises:
storing trimming settings for the resistor arrangement and/or the capacitor arrangement;
sensing the temperature; and
applying a trimming setting to the resistor arrangement and/or the capacitor arrangement in dependence on the sensed temperature.

7. A method as claimed in claim 5, wherein the resistor arrangement is fixed and the capacitor arrangement is tuneable.

8. A method as claimed in claim 5, wherein the resistor arrangement is tuneable and the capacitor arrangement is fixed.

9. A method as claimed in any one of claims 6 to 8, comprising selecting a trimming setting which has a value which varies at predetermined temperature thresholds (T₁-T₆).

10. A method as claimed in claim9, wherein the trimming settings have hysteresis such that there are upper thresholds (T₂,T₄,T₆) at which the trimming setting changes in response to an increasing temperature, and lower thresholds at (T₁,T₃,T₅) which the trimming setting changes in response to a decreasing temperature.
